# EUROPÄISCHE PATENTSCHRIFT

(11) **EP 2 812 461 B1**
(45) Veröffentlichungstag und Bekanntmachung des Hinweises auf die Patenterteilung: **09.11.2016**
(21) Anmeldenummer: 13707119.7
(22) Anmeldetag: 06.02.2013
(51) Int. Cl.: C23C 16/40, C23C 16/509, C23C 16/455, H01J 37/32, H01L 31/0216, H01L 31/18

(54) **VERFAHREN ZUR PASSIVIERUNG VON SOLARZELLEN MIT EINER ALUMINIUMOXID-SCHICHT**
METHOD FOR PASSIVATING SOLAR CELLS WITH AN ALUMINIUM OXIDE LAYER
PROCÉDÉ DE PASSIVATION DE CELLULES SOLAIRES AU MOYEN D'UNE COUCHE D'OXYDE D'ALUMINIUM

(30) Priorität: 09.02.2012 DE 102012201953
(43) Veröffentlichungstag der Anmeldung: 17.12.2014
(73) Patentinhaber: Singulus Technologies AG, 63796 Kahl am Main (DE)
(72) Erfinder: DIPPELL, Torsten, 63225 Langen (DE); ROOS, Björn, 63579 Freigericht (DE); HOHN, Oliver, 63584 Gründau (DE); DULLWEBER, Thorsten, 31812 Bad Pyrmont (DE); HARDER, Nils-Peter, San Jose, CA 95130 (US); SIEBERT, Michael, 31785 Hameln (DE)
(74) Vertreter: Vossius & Partner Patentanwälte Rechtsanwälte mbB
(86) Internationale Anmeldenummer: PCT/EP2013/052298
(87) Internationale Veröffentlichungsnummer: WO 2013/117576

(56) Entgegenhaltungen:
- EP-A1- 0 877 410
- DE-A1-102009 018 700
- US-A1- 2002 004 309
- US-A1- 2008 199 632
- J. W. LEE ET AL: JOURNAL OF THE ELECTROCHEMICAL SOCIETY, Bd. 147, Nr. 4, 1. Januar 2000 (2000-01-01), Seiten 1481-1486, XP055060921,
- S. H. LEE ET AL: SURFACE AND COATINGS TECHNOLOGY, Bd. 153, 1. Januar 2002 (2002-01-01), Seiten 67-71, XP055060940,
- B.F.P. ROOS ET AL: "ICP-PECVD Production Tool for Industrial AlOx and Si-Based Passivation Layers", 27TH EUROPEAN PHOTOVOLTAIC SOLAR ENERGY CONFERENCE AND EXHIBITION, 2012, Seiten 1684-1687, XP055060904, DOI: 10.4229/27thEUPVSEC2012-2CV.5.17

## Beschreibung

Die vorliegende Erfindung betrifft ein Verfahren und ein System zur Beschichtung eines Substrats mit einer Aluminiumoxid-Schicht, insbesondere zur OberflächenPassivierung von Solarzellen.

Durch ungebundene Zustände an der Oberfläche z.B. eines Halbleiters können Elektronen und Löcher rekombinieren oder sich Verschmutzungen (z.B. Feuchtigkeit) festsetzen. Daher kann der Rekombinationsprozess über ungebundene Zustände für elektronische Bauelemente, wie z.B. Halbleiterbauelemente und/oder Solarzellen, schädlich sein und die Lebensdauer dieser Bauteile verringern. Zudem ist auch die Vorhersagbarkeit und Berechenbarkeit der Funktionsweise dieser Bauelemente aufgrund von möglichen Rekombinationsprozessen an den Oberflächen nicht ganz genau möglich.

Aus diesen Gründen wurde versucht, die Oberfläche derartiger Bauelemente mit einer Beschichtung zu versehen, die als Oberflächenpassivierung dienen soll. Derartige Passivierungsschichten sind z.B. für hocheffiziente Solarzellen von besonderem Interesse (z.B. Rückseitenpassivierung einer PERC (passivated emitter and rear cell) Solarzelle oder die Vorderseite einer n-type Solarzelle).

In der DE-A1-102007054384 wurde z.B. vorgeschlagen, zur Oberflächenpassivierung eine Dielektrikum-Doppelschicht zur Passivierung einer Solarzelle zu verwenden. Die erste Schicht war hierbei eine dünne Aluminiumoxid-Schicht, die durch sequentielle Gasphasenabscheidung (Atomic Layer Deposition, ALD) aus einem Aluminium-haltigen Gas gebildet wurde, während die zweite, dickere Schicht Silizium-Nitrid oder Silizium-Oxid oder Silizium-Karbid enthielt und mittels plasmaunterstützter chemischer Gasphasenabscheidung (Plasma Enhanced Chemical Vapour Deposition, PECVD) gebildet wurde.

Obwohl derartige Verfahren bereits hinsichtlich der Qualität der Rückseitenpassivierung in der kristallinen Solarzellenproduktion recht gute Ergebnisse liefern, ist ein hoher Durchsatz an Zellen pro Stunde bei gleichzeitigem niedrigen Verbrauch an Aluminium-haltigen Gas kaum möglich.

Angesichts unzureichender Schichtabscheideraten der ALD Technik wird in der US 2008/0199632 A1 gepulstes PECVD Abscheiden von Aluminiumoxid unter Verwendung eines induktiv gekoppelten Plasmas vorgeschlagen.

Der vorliegenden Erfindung liegt die Aufgabe zugrunde, ein Verfahren bereitzustellen, das geeignet ist, oberflächenpassivierte Bauteile mit hohem Durchsatz und bei niedrigem Verbrauch an Prozessgasen wie z.B. Aluminium-haltigem Gas, herzustellen, ohne auf eine hohe Qualität der Schichten zu verzichten.

Diese Aufgabe wird mit den Merkmalen der Patentansprüche gelöst.

Die Erfindung geht aus von dem Konzept, zur Abscheidung einer Passivierungsschicht, z.B. Aluminiumoxid, ein induktiv gekoppeltes Plasma (inductively coupled plasma, ICP) zu verwenden, wobei die ICP-Quelle eine Reaktionskammer und mindestens einem HF-Induktor umfasst und auf diese Weise geeignet ist, die für die Erzeugung des Plasmas nötige Energie direkt in die Reaktionskammer einzukoppeln.

Dadurch kann z. B. eine hohe Umsetzung der Reaktionsprodukte und eine hohe Beschichtungsrate erreicht werden. Auf diese Weise kann auch die Umsatzrate für qualitativ hochwertige Schichten (geringe Defektdichte und gute Homogenität auch auf großen Flächen) erhöht werden.

Die Erfindung betrifft ein Verfahren zum Beschichten eines Substrats mit einer AlOₓ-Schicht, insbesondere Al₂O₃-Schicht. Hierbei wird eine induktiv gekoppelte Plasmaquelle (ICP-Quelle) mit einer Reaktionskammer und mindestens einem HF-Induktor bereitgestellt. Eine Aluminiumverbindung, vorzugsweise Trimethylaluminium (TMA) und/oder Dimethylaluminiumisopropoxid (DMAI), und Sauerstoff und/oder eine Sauerstoffverbindung als Reaktivgas werden in die ICP-Quelle eingeleitet. Zum Ausbilden eines Plasmas wird Energie induktiv in die ICP-Quelle eingekoppelt und die AlOₓ-Schicht auf dem Substrat abgeschieden.

Ein Plasma umfasst frei bewegliche Elektronen, Ionen, Moleküle, Neutrale und Radikale. Ein Plasma kann z.B. verwendet werden, um nicht reaktive Moleküle unter anderem in elektrisch geladene und/oder angeregte, reaktive Moleküle und/oder Radikale umzuwandeln, wobei die Reaktivität und die Verteilung des Plasmas z.B. durch angelegte elektrische und/oder magnetische Felder kontrolliert werden kann.

Gemäß der vorliegenden Erfindung wird die erforderliche Energie zur Erzeugung des Plasmas über einen Hochfrequenz(HF)-Induktor in die mit Prozessgasen gefüllte Reaktionskammer eingekoppelt.

Zur Herstellung elektronischer Bauteile, z.B. für die Halbleiter und/oder Solarzellenindustrie, ist es vorteilhaft, ein Plasma mit niedrigen Ionenenergien zu verwenden. Bestimmte Reaktionsgase können hierfür z.B. über Kanäle in die Reaktionskammer eingeleitet werden.

Die angeregten Gase können mit schichtbildenden Stoffen (z.B. TMA, DMAI, (CH₃)₃Al oder SiH₄) reagieren, wodurch sich Schichten von neuen Verbindungen an der Substratoberfläche ausbilden, in denen Elemente aus allen Reaktionspartnern vorkommen können.

Zur Aluminiumoxid-Beschichtung kann z.B. Sauerstoffgas (O₂) verwendet werden, während für die Herstellung einer Siliziumnitrid-Schicht ein stickstoff-haltiges Reaktivgas, wie z.B. NH₃, genutzt werden kann.

Die induktiv eingekoppelte Energie einer ICP-Plasmaquelle kann vorteilhaft zu einer höheren Plasmadichte führen. Auf diese Weise kann das Verfahren bei niedrigem Druck durchgeführt werden, so dass die abgeschiedene Schicht eine gute Homogenität über eine relativ große Fläche (z.B. in der Größenordnung von 100 mm x 100 mm, 150 mm x 150 mm, 156 mm x 156 mm oder auch mehr) mit besonderer Schichtzusammensetzung bei gleichzeitiger hoher Beschichtungsrate aufweisen kann.

In einer Ausführungsform werden die Plasmadichte und die Ionenenergie unabhängig voneinander gesteuert. Zum Beispiel kann die Plasmadichte mindestens 1x10¹¹ Ionen/cm³, vorzugsweise 1x10¹² Ionen/cm³ bis 9x10¹³Ionen/cm³ betragen. Unabhängig davon kann die Ionenenergie in einer Ausführungsform zwischen 1 und 30 eV, vorzugsweise weniger als 20 eV, betragen. Dadurch dass die Ionenenergie und die Plasmadichte unabhängig voneinander gesteuert werden können, ist es möglich, hohe Plasmadichten zu erreichen, ohne die Oberfläche des Substrats, oder das Substrat selbst, insbesondere den Emitter zu schädigen.

In einer Ausführungsform liegt ein Vakuum von 10⁻⁴ bis 10⁻¹ mbar, vorzugsweise von 10⁻³ bis 5*10⁻² mbar, in der Reaktionskammer vor. Dieser Druck in der Reaktionskammer ermöglicht die Herstellung von sehr homogenen Schichten auch auf großen Oberflächen, so dass auf diese Weise der Durchsatz der beschichteten Bauteile erhöht werden kann.

In einer Ausführungsform wird das induktive Einkoppeln von Energie mit einer Frequenz von 1 - 60 MHz, vorzugsweise mit 13,56 MHz, durchgeführt. Aufgrund der direkten Energieeinkopplung durch den HF-Induktor kann somit eine hohe Plasmadichte und damit eine hohe Beschichtungsrate erreicht werden.

In einer Ausführungsform besteht das Substrat aus Silizium. Silizium wird hierbei vorzugsweise für die Herstellung und/oder Beschichtung von Halbleitern und/oder Solarzellen verwendet. Insbesondere kann die Verwendung von kristallinem Silizium von Vorteil sein, da kristalline Siliziumsolarzellen gerade bei Betrieb über einen längeren Zeitraum von mehreren Jahren (bis zu 20 Jahre oder mehr) nur geringe Verluste aufgrund von Degradation erfahren.

In einer Ausführungsform kann eine weitere Schicht, insbesondere ein Dielektrikum, auf der Aluminiumoxid-Schicht abgeschieden werden. Hierzu kann das Verfahren vorsehen, dass das Substrat, das mit der AlOₓ-Schicht versehen ist, entweder in der gleichen Kammer verbleibt oder in eine weitere Reaktionskammer mit einer weiteren ICP-Quelle transportiert wird. In die zweite ICP-Quelle wird vorzugsweise eine Siliziumverbindung zugeführt und Stickstoff oder Sauerstoff oder eine Kohlenwasserstoffverbindung (wie z.B. CH₂) und/oder eine Stickstoff-Verbindung oder eine Sauerstoff-Verbindung oder eine Kohlenwasserstoffverbindung-Verbindung als Reaktivgas in die zweite ICP-Quelle eingeleitet. Zum Ausbilden eines Plasmas wird Energie in die zweite ICP-Quelle eingekoppelt, und dann eine betreffende SiN_{y}- oder SiOₓ- oder SiC_{z}-Schicht auf der AlOₓ-Schicht abgeschieden.

Auf diese Weise kann z.B. ein Passivierungsstapel aus zwei oder mehr Schichten auf dem Substrat auf einfache Weise hergestellt werden. Insbesondere kann die weitere (zweite) Reaktionskammer direkt neben der ersten Reaktionskammer in der gleichen Beschichtungsanlage angeordnet sein. Daher kann auf das soeben mit der ersten Schicht beschichtete Substrat ohne aufwendiges Ein- und/oder Ausschleusen des (beschichteten) Substrats eine weitere Schicht, insbesondere aus einem anderen Material, in einem weiteren Prozessschritt in der gleichen Beschichtungsanlage aufgebracht werden.

Die vorliegende Offenbarung betrifft auch eine Beschichtungsanlage zum Abscheiden von dünnen Schichten auf einem Substrat, insbesondere zur Durchführung eines der oben beschriebenen Verfahren. Die Beschichtungsanlage kann hierbei insbesondere geeignet sein, die oben beschriebenen Prozessparameter zu verwirklichen.

Erfindungsgemäß umfasst die verwendete Beschichtungsanlage eine induktiv gekoppelte Plasmaquelle (ICP) mit einer Reaktionskammer und mindestens einem HF-Induktor, eine Substrathalterung zur Anordnung eines Substrats, insbesondere mehrerer Substrate, in der Reaktionskammer und Kanälen zum Einleiten der Aluminiumverbindung und eines Reaktivgases in die ICP-Quelle. Das Substrat ist hierbei derart in der Reaktionskammer angeordnet, dass die zu beschichtende Oberfläche des Substrats zur ICP-Quelle weist.

Die induktiv gekoppelte Plasmaquelle umfasst hierbei die Reaktionskammer und mindestens einen Induktor, der mit einer hochfrequenten Stromquelle verbunden ist. Auf diese Weise kann in die Reaktionskammer direkt die für die Erzeugung des Plasmas nötige Energie eingekoppelt werden. Vorzugsweise sind zudem Kanäle zum Einleiten von Reaktivgas und/oder zum Einleiten eines z.B. fluiden Präkursors (wie z.B. TMA) in die Plasmaquelle vorgesehen. Durch die Anordnung des Substrats derart, dass die zu beschichtende Oberfläche des Substrats in Richtung Plasmaquelle weist, kann die Beschichtungsrate optimiert und somit der Durchsatz der beschichteten Bauteile erhöht werden.

In einer Ausführungsform umfasst die Beschichtungsanlage mindestens eine zweite induktiv gekoppelte Plasmaquelle (ICP) mit einer Reaktionskammer und mindestens einem HF-Induktor und Kanälen zum Einleiten einer Siliziumverbindung und eines Reaktivgases in die zweite/weiteren ICP-Quelle(n).

Vorzugsweise kann die Beschichtungsanlage derart ausgebildet sein, dass sie mehrere Prozessstationen aufweist, die mit ICP-Quellen und entsprechenden Reaktionskammern und Kanälen ausgestattet sind. In einer Ausführungsform umfasst die Beschichtungsanlage auch Transportmechanismen, so dass ein insbesondere beschichtetes Substrat von einer ersten in eine zweite Prozessstation, insbesondere in eine zweite Plasmaquelle mit Reaktionskammer zugeführt werden kann. In der zweiten Prozessstation/Quelle/Reaktionskammer kann dann eine weitere Beschichtung vorgenommen werden, insbesondere zur Herstellung einer (zu der ersten Schicht) unterschiedlichen Schicht. Zudem können noch weitere Beschichtungen in weiteren Prozessstationen/Quellen/Reaktionskammern vorgesehen werden.

In einer Ausführungsform ist der Induktor der ICP-Quelle bzw. der ICP-Quellen außerhalb der zugehörigen Reaktionskammer angeordnet und von dieser durch eine dielektrische Trennwand getrennt. Vorzugsweise trennt die dielektrische Wand die Reaktionskammer von dem Bereich des Induktors mit der hochfrequenten Stromquelle derart ab, dass diese insbesondere einen Schutz für den Induktor darstellt und sich das Plasma kontrolliert und gerichtet ausbilden kann.

Die hier beschriebenen Verfahren und Beschichtungsanlage können z. B. zur Passivierung, insbesondere zur Rückseitenpassivierung von Solarzellen, vorzugsweise von kristallinen Solarzellen, angewendet werden.

Das erfindungsgemäße Verfahren und die entsprechende Beschichtungsanlage ermöglichen die Herstellung von qualitativ hochwertigen, defektarmen homogenen Schichten (Niederdruck). Durch die hohe Dissoziation von Sauerstoff und die hohe Umsatzrate des Aluminium-haltigen Gases, insbesondere TMA, und/oder DMAI, in der Quelle wird zudem ein hoher Durchsatz an beschichteten Substraten, z.B. Solarzellen mit hoher Zelleffizienz, bei gleichzeitigem niedrigen Verbrauch an TMA und/oder DMAI ermöglicht. Auf diese Weise sinken die Materialkosten pro Wafer bzw. pro Watt deutlich.

Ein weiterer Vorteil gegenüber bereits bekannten Verfahren bzw. Beschichtungsanlagen besteht darin, dass diese Verfahren in einer einzigen Anlage (z.B. mit mehreren Reaktionskammern, die den gleichen Druck oder unterschiedliche Drücke aufweisen, und/oder mit geeigneten Transportmechanismen zwischen den einzelnen Kammern) durchgeführt werden können: so kann z.B. der gesamte Rückseitenschichtstapel aus einer Aluminiumoxid- und einer Siliziumnitrid-Schicht in einer Plattform (eine derartige Plattform ist z.B. aus der DE 10 2009 018 700 bekannt) stattfinden, was mit einem ALD-Verfahren und entsprechende -Anlage nicht möglich ist. In einer Ausführungsform kann das erfindungsgemäße Verfahren im Takt-Betrieb ausgeführt werden bzw. die Beschichtungsanlage im Takt-Betrieb arbeiten. Zum Beispiel kann sich auf diese Weise mindestens ein Substrat in einer ersten Reaktionskammer (oder einer anderen Prozessstation) befinden, während sich zur gleichen Zeit in einer zweiten Reaktionskammer (oder einer wieder anderen Prozessstation) mindestens ein weiteres Substrat befindet usw. Auf diese Weise ist es nicht mehr nötig, dass ein einziges Substrat oder eine einzige Gruppe von Substraten einen kompletten Beschichtungsvorgang in der Anlage durchläuft, bevor die Beschichtungsanlage mit einem nächsten Substrat oder einer nächsten Gruppe von Substraten zur Beschichtung befüllt wird: Sobald der erste Prozessschritt z.B. in einer ersten Kammer abgeschlossen ist, kann das Substrat (beziehungsweise die Gruppe an Substraten) in eine weitere Kammer zur Weiterverarbeitung transportiert werden, während vorzugsweise im gleichen Moment die erste Kammer mit einem nächsten Substrat bzw. einer nächsten Substrat-Gruppe befüllt wird usw.. Zum Beispiel kann ein Substrat oder eine Gruppe von Substraten im Takt-Betrieb im Kreis die einzelnen Stationen der Beschichtungsanlage durchlaufen. Auf diese Weise verkürzt sich die Zykluszeit, was wiederum zu einem erhöhten Durchsatz, z.B. bei getaktetem Betrieb ohne Ausschleusen, führt.

Einige der oben beschriebenen, insbesondere voneinander unabhängigen, Prozessparameter, insbesondere zur Aluminiumoxid-Beschichtung, können wie folgt zusammengefasst werden:
Druck: 10⁻⁴ bis 10⁻¹ mbar, vorzugsweise von 10⁻³ bis 5*10⁻² mbar
Substrattemperatur: Raumtemperatur bis 450° C
Radiofrequenz: 1 - 60 MHz, vorzugsweise 13,56 MHz
Plasmaleistung: 0,5 bis 10 kW, vorzugsweise 3,5 bis 6 kW
Ionenenergie: 1 eV bis 30 eV, vorzugsweise weniger als 20 eV
Plasmadichte: mindestens 1x10¹¹ Ionen/cm³, vorzugsweise von 1x10¹² Ionen/cm³ bis 9x10¹³Ionen/cm³
Ionisationsgrad: bis zu 50%
Dissoziationsgrad: 2-atomige Moleküle (O₂) bis zu 80%
Plasmaqualität: partikelfreier Plasmastrahl durch Niederdruck

Die Erfindung wird nachstehend mit Bezug auf die Zeichnungen näher erläutert. Es zeigen:
Fig. 1 eine schematische Darstellung einer Prozessstation einer ICP-PECVD-Beschichtungsanlage,
Fig. 2 eine schematische Ansicht mehrerer Prozessstationen einer ICP-PECVD-Beschichtungsanlage und
Fig. 3 eine schematische Darstellung einer Prozessstation einer ICP-PECVD-Beschichtungsanlage mit dielektrischer Trennwand.

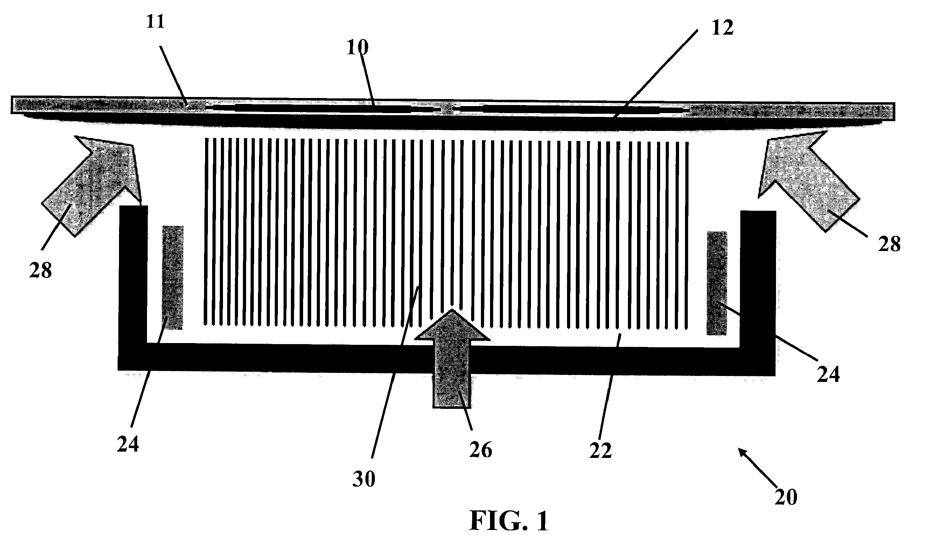

Fig. 1 zeigt einen schematischen Querschnitt durch einen Teil, insbesondere eine Prozessstation, einer Beschichtungsanlage mit einem Substrathalter 11 und den Substraten 10. Die Prozessstation umfasst eine ICP-Quelle 20 unterhalb des Substrathalters 11 mit den Substraten 10 mit einer Reaktionskammer 22 und mindestens einem umlaufenden HF-Induktor 24. Der HF-Induktor 24 befindet sich in dieser Ausführungsform an den seitlichen Innenwänden der ICP-Quelle und definiert somit die seitlichen Abgrenzungen der Reaktionskammer 22. Die ICP-Quelle weist zudem Kanäle 28 auf, durch die ein fluider Präkursor, z.B. TMA und/oder DMAI, in die Reaktionskammer eingeleitet werden kann. Ein Reaktivgas, z.B. Sauerstoff, kann ebenfalls über einen dieser Kanäle oder einen weiteren Kanal 26 der Kammer 22 zugeführt werden.

Nach der direkten induktiven Einkopplung der Energie, entsteht ein Plasma 30, das in Richtung der zu beschichtenden Unterseite des Substrats 10 ausgebildet wird.

Letztendlich kann auf diese Weise eine dünne Schicht 12, z.B. aus einem Aluminiumoxid, auf dem Substrat 10 abgeschieden werden.

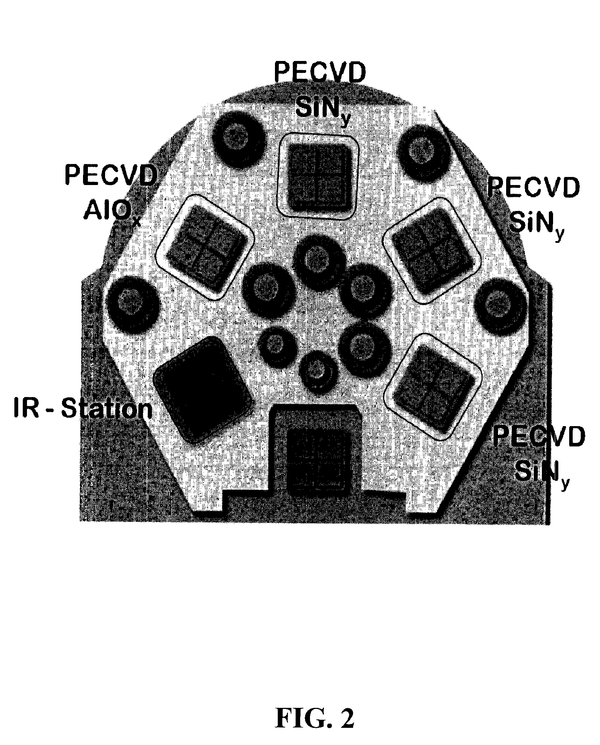

Fig. 2 zeigt eine schematische Ansicht mehrerer Prozessstationen. Neben einer IR-Station zum Aufheizen des Substrats befinden sich mehrere ICP-Quellen, die z.B. nacheinander im Uhrzeigersinn und/oder in willkürlicher Reihenfolge mit dem Substrat über Transportmechanismen angefahren werden können. Zur Kontrolle der Substrattemperatur kann mindestens ein Temperaturfühler (nicht dargestellt) vorgesehen sein.

Alternativ ist es auch möglich, dass das Substrat in einer Halterung verbleibt und die einzelnen Stationen/Quellen/Kammern an eine Seite des Substrat angebracht werden können (z.B. durch Drehung der Ebene der Kammern parallel zur Substratebene), so dass das Substrat beschichtet werden kann.

Dabei ist es jeweils möglich, ein Substrat in einer Anlage mit verschiedenen Materialien zu beschichten. Zum Beispiel kann auf das Substrat zunächst eine Aluminiumoxid-Schicht unter Nutzung von TMA und/oder DMAI als Präkursor und Sauerstoff als Reaktivgas abgeschieden werden, und danach unter Nutzung von SiH₄ als Präkursor und NH₃ als Reaktivgas eine Siliziumnitrid-Schicht auf die Aluminiumoxid-Schicht aufgebracht werden.

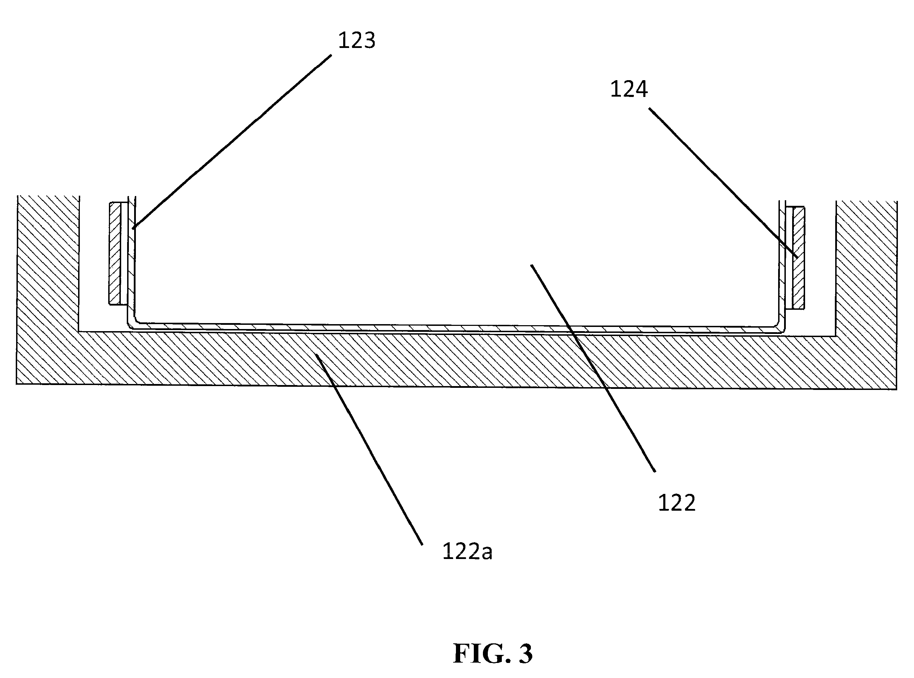

Fig. 3 zeigt einen schematischen Querschnitt durch einen Teil, insbesondere eine Prozessstation, einer Beschichtungsanlage. Die Prozessstation kann in einer Ausführungsform im Wesentlichen auch die Merkmale der Prozessstation aus Fig. 1 umfassen und zeigt eine untere Kammerwand 122a. Im Gegensatz zu Fig. 1 weist die ICP-Quelle in Fig. 3 eine dielektrische Trennwand 123 auf, die den HF-Induktor 124 von der Reaktionskammer 122 abtrennt. Mit anderen Worten können die äußeren Abmessungen der dielektrischen Trennwand 123 mindestens eine Seitenwand der Reaktionskammer definieren und/oder wannen- und/oder ring-förmig in der Quelle angeordnet sein. Die dielektrische Trennwand kann insbesondere einen Schutz für den Induktor darstellen und dazu dienen, dass sich das Plasma kontrolliert und auf die zu beschichtende Oberfläche des Substrats gerichtet ausbilden kann.

Das erfindungsgemäße Verfahren und die entsprechende Beschichtungsanlage ermöglichen somit die Herstellung von qualitativ hochwertigen Schichten bei niedrigem Prozessdruck und geringen Materialkosten. Ein weiterer Vorteil gegenüber bereits bekannten Verfahren bzw. Beschichtungsanlagen besteht darin, dass diese Verfahren in einer einzigen Anlage durchgeführt werden können, so dass sich die Zykluszeit verkürzt und sich damit der Durchsatz erhöht.

## Patentansprüche

1. Verfahren zum Beschichten eines Substrats (10) mit einer AlOₓ-Schicht (12), insbesondere Al₂O₃-Schicht, mit den folgenden Verfahrensschritten:
(a) Bereitstellen einer induktiv gekoppelten Plasmaquelle (ICP-Quelle) (20), mit einer Reaktionskammer (22) und mindestens einem HF-Induktor (24),
(b) Einleiten einer Aluminiumverbindung, in die ICP-Quelle (20),
(c) Einleiten von Sauerstoff und/oder einer Sauerstoffverbindung als Reaktivgas in die ICP-Quelle und induktives Einkoppeln von Energie in die ICP-Quelle (20) zum Ausbilden eines Plasmas (30), und
(d) Abscheiden der AlOₓ-Schicht (12) auf dem Substrat (10),
**dadurch gekennzeichnet, dass**
die ICP-Quelle (20) die Reaktionskammer (22) und den mindestens einem HF-Induktor (24) umfasst und auf diese Weise geeignet ist, die für die Erzeugung des Plasmas nötige Energie direkt in die Reaktionskammer (22) einzukoppeln.

2. Verfahren nach Anspruch 1, wobei das Substrat (10) aus Silizium besteht.

3. Verfahren nach Anspruch 1 oder 2, wobei die Plasmadichte mindestens 1x10¹¹ Ionen/cm³, vorzugsweise von 1x10¹² Ionen/cm³ bis 9x10¹³Ionen/cm³, beträgt.

4. Verfahren nach einem der Ansprüche 1 bis 3, wobei die Ionenenergie zwischen 1 und 30 eV beträgt.

5. Verfahren nach einem der Ansprüche 1 bis 4, wobei ein Vakuum von 10⁻⁴ bis 10⁻¹ mbar, vorzugsweise von 10⁻³ bis 5*10⁻² mbar, in der Reaktionskammer (22) vorliegt.

6. Verfahren nach einem der Ansprüche 1 bis 5, wobei das induktive Einkoppeln von Energie mit einer Frequenz von 1 - 60 MHz, vorzugsweise mit 13,56 MHz, durchgeführt wird.

7. Verfahren nach einem der Ansprüche 1 bis 6, mit einem Schritt (e) Abscheiden einer SiN_{y}-Schicht auf der AlOₓ-Schicht (12) in der Reaktionskammer (22) unter Verwendung der ICP-Quelle (20) oder einer weiteren ICP-Quelle, oder in einer weiteren Reaktionskammer unter Verwendung einer weiteren ICP-Quelle.

8. Verfahren nach Anspruch 7, wobei Schritt (e) folgende Schritte aufweist:
(e1) Zuführen einer Siliziumverbindung in die ICP-Quelle (20) bzw. in die weitere ICP-Quelle, und
(e2) Einleiten von Stickstoff und/oder einer Stickstoffverbindung als Reaktivgas in diese ICP-Quelle und induktives Einkoppeln von Energie in diese ICP-Quelle zum Ausbilden eines Plasmas.

9. Verfahren nach einem der Ansprüche 1 bis 8, wobei die Substrattemperatur im Bereich von Raumtemperatur bis 450° C liegt.

10. Verfahren nach einem der Ansprüche 1 bis 9, wobei die Plasmaleistung 0,5 bis 10 kW, vorzugsweise 3,5 bis 6 kW, beträgt.

11. Verfahren nach einem der Ansprüche 1 bis 10, wobei die Plasmadichte und die Ionenenergie unabhängig voneinander gesteuert werden.

12. Anwendung des Verfahrens nach einem der Ansprüche 1 bis 11 zur Passivierung, insbesondere zur Rückseitenpassivierung von Solarzellen, vorzugsweise von kristallinen Solarzellen.

## Claims

1. Method for coating a substrate (10) with an AlOₓ layer (12), in particular an Al₂O₃ layer, comprising the following method steps:
(a) providing an inductively coupled plasma source (ICP source) (20) comprising a reaction chamber (22) and at least one RF inductor (24),
(b) introducing an aluminium compound into the ICP source (20),
(c) introducing oxygen and/or an oxygen compound as reactive gas into the ICP source and inductively coupling of energy into the ICP source (20) for forming a plasma (30), and
(d) depositing the AlOₓ layer (12) on the substrate (10),
**characterised in that**
the ICP source (20) comprises the reaction chamber (22) and the at least one RF inductor (24) and is thus suitable for coupling the energy necessary for forming the plasma directly into the reaction chamber (22).

2. The method according to claim 1, wherein the substrate (10) consists of silicon.

3. The method according to claim 1 or 2, wherein the plasma density is at least 1x10¹¹ ions/cm³, preferably 1x10¹² ions/cm³ to 9x10¹³ ions/cm³.

4. The method according to any one of claims 1 to 3, wherein the ion energy ranges between 1 and 30 eV.

5. The method according to any one of claims 1 to 4, wherein there is a vacuum of 10⁻⁴ to 10⁻¹ mbar, preferably of 10⁻³ to 5*10⁻² mbar, in the reaction chamber (22).

6. The method according to any one of claims 1 to 5, wherein the inductive coupling of energy is carried out with a frequency of 1-60 MHz, preferably with 13.56 MHz.

7. The method according to any one of claims 1 to 6, comprising a step of (e) depositing an SiN_{y} layer on the AlOₓ layer (12) in the reaction chamber (22) using the ICP source (20) or a further ICP source, or in a further reaction chamber using a further ICP source.

8. The method according to claim 7, wherein step (e) comprises the following steps:
(e1) introducing a silicon compound into the ICP source (20) or into the further ICP source, and
(e2) introducing nitrogen and/or a nitrogen compound as reactive gas into this ICP source and inductively coupling of energy into this ICP source for forming a plasma.

9. The method according to any one of claims 1 to 8, wherein the substrate temperature is in the range of room temperature up to 450°C.

10. The method according to any one of claims 1 to 9, wherein the plasma power is 0.5 to 10 kW, preferably 3.5 to 6 kW.

11. The method according to any one of claims 1 to 10, wherein the plasma density and the ion energy are controlled independently from each other.

12. Use of the method according to any one of claims 1 to 11 for passivation, in particular for back side passivation of solar cells, preferably of crystalline solar cells.

## Revendications

1. Procédé de revêtement d'un substrat (10) avec une couche AlOₓ (12), en particulier une couche Al₂O₃, comprenant les étapes suivantes :
(a) préparation d'une source de plasma couplée inductivement (source ICP) (20), avec une chambre de réaction (22) et au moins un inducteur HF (24),
(b) application d'un composé d'aluminium dans la source ICP (20),
(c) application d'oxygène et/ou d'un composé d'oxygène en tant que gaz réactif dans la source ICP et couplage inductif d'énergie dans la source ICP (20) pour former un plasma (30), et
(d) dépôt de la couche AlOₓ (12) sur le substrat (10),
**caractérisé en ce que**
la source ICP (20) comprend la chambre de réaction (22) et ledit au moins un inducteur HF (24) et est ainsi adaptée au couplage direct dans la chambre de réaction (22) de l'énergie exigée pour la génération du plasma.

2. Procédé selon la revendication 1, où le substrat (10) est en silicium.

3. Procédé selon la revendication 1 ou la revendication 2, où la densité du plasma est d'au moins 1x10¹¹ ions/cm³, préférentiellement de 1x10¹² ions/cm³ à 9x10¹³ ions/cm³.

4. Procédé selon l'une des revendications 1 à 3, où l'énergie ionique est comprise entre 1 et 30 eV.

5. Procédé selon l'une des revendications 1 à 4, où un vide compris entre 10⁻⁴ et 10⁻¹ mbar, préférentiellement entre 10⁻³ et 5*10⁻² mbar, est présenté dans la chambre de réaction (22).

6. Procédé selon l'une des revendications 1 à 5, où le couplage inductif d'énergie est exécuté à une fréquence comprise entre 1 et 60 MHz, préférentiellement égale à 13,56 MHz.

7. Procédé selon l'une des revendications 1 à 6, comprenant une étape (e) de dépôt d'une couche SiN_{y} sur la couche AlOₓ (12) dans la chambre de réaction (22) en utilisant la source ICP (20) ou une autre source ICP, ou dans une autre chambre de réaction en utilisant une autre source ICP.

8. Procédé selon la revendication 7, où l'étape (e) comprend les étapes suivantes :
(e1) amenée d'un composé de silicium dans la source ICP (20) ou dans l'autre source ICP, et
(e2) application d'azote et/ou d'un composé d'azote en tant que gaz réactif dans ladite source ICP et couplage inductif d'énergie dans ladite source ICP pour former un plasma.

9. Procédé selon l'une des revendications 1 à 8, où la température du substrat est comprise dans la plage de température ambiante jusqu'à 450° C.

10. Procédé selon l'une des revendications 1 à 9, où la puissance du plasma est comprise entre 0,5 et 10 kW, préférentiellement entre 3,5 et 6 kW.

11. Procédé selon l'une des revendications 1 à 10, où la densité du plasma et l'énergie ionique sont commandées indépendamment l'une de l'autre.

12. Utilisation du procédé selon l'une des revendications 1 à 11 pour la passivation, en particulier pour la passivation de la face arrière de cellules solaires, préférentiellement de cellules solaires cristallines.
